# EUROPÄISCHE PATENTSCHRIFT

(11) **EP 3 231 254 B1**
(45) Veröffentlichungstag und Bekanntmachung des Hinweises auf die Patenterteilung: **03.03.2021**
(21) Anmeldenummer: 15804484.2
(22) Anmeldetag: 03.12.2015
(51) Int. Cl.: H05B 33/08, G06K 19/077

(54) **LED-MODUL**
LED- MODUL
MODULE DE DEL

(30) Priorität: 12.12.2014 DE 102014225720
(43) Veröffentlichungstag der Anmeldung: 18.10.2017
(73) Patentinhaber: Bundesdruckerei GmbH, 10969 Berlin (DE)
(72) Erfinder: FISCHER, Jörg, 13053 Berlin (DE); HILLE, Jakob, 14199 Berlin (DE); TIETKE, Markus, 12439 Berlin (DE); PAESCHKE, Manfred, 16348 Wandlitz (DE)
(74) Vertreter: Richardt Patentanwälte PartG mbB
(86) Internationale Anmeldenummer: PCT/EP2015/078467
(87) Internationale Veröffentlichungsnummer: WO 2016/091704

(56) Entgegenhaltungen:
- EP-A1- 1 134 694
- EP-A2- 1 795 915
- EP-A2- 1 863 093
- WO-A1-2013/114244
- DE-A1-102005 062 827
- DE-A1-102008 024 780
- DE-A1-102010 028 444
- DE-A1-102012 203 251
- DE-A1-102013 207 998
- DE-A1-102013 210 842
- DE-B3-102006 008 345
- US-A1- 2008 308 641
- US-A1- 2012 038 445
- Das Fraunhofer ET AL: "Transponder Systeme (RFID) @BULLET Transponder Systeme @BULLET Passive Systeme @BULLET Aktive Systeme @BULLET Design und Simulation @BULLET Aufbau-und Verbindungstechnik @BULLET Produktionstechnik @BULLET Service und Leistung des Fraunhofer IZM Transponder-Systeme", , 1. April 2011 (2011-04-01), XP055263976, Gefunden im Internet: URL:http://www.izm.fraunhofer.de/content/d am/izm/en/documents/Publikationen/Themenbr oschueren/trnsp04d.pdf [gefunden am 2016-04-08]

## Beschreibung

Die Erfindung betrifft ein LED-Modul sowie ein elektronisches System.

Aus DE 10 2012 218 927 A1 ist ein LED-Modul bekannt, bei dem eine LED direkt mit einem Substrat verbunden wird.

Aus der DE 10 2013 106 858 A1 ist ein weiteres Verfahren zur Herstellung eines solchen LED-Moduls bekannt.

DE 10 2012 203 251 A1 beschreibt eine kontaktlose Datenübertragungseinrichtung, welche einen elektrisch isolierenden Träger, ein auf dem Träger angeordnetes Schaltkreiselement aus einem durchgehenden Antennen-Leiterzug in Form mindestens einer Spiralwindung und jeweils einem Anschlusskontakt an dessen Enden sowie ein mit dem Schaltkreiselement elektrisch verbundenes elektronisches Bauelement mit mindestens zwei Kontaktstellen aufweist. Das elektronische Bauelement ist in einem Montagebereich über der mindestens einen Spiralwindung platziert. Die mindestens zwei Kontaktstellen des Bauelements sind mit jeweils einem Anschlusskontakt des Antennen-Leiterzuges elektrisch verbunden. Mindestens eine Spiralwindung verzweigt sich außerhalb des Montagebereiches zwischen jeweils zwei Verzweigungsstellen in mindestens zwei Spiralwindungsäste. Die Datenübertragungseinrichtung ist Bestandteil eines Wert- und/oder Sicherheitsdokuments.

DE 10 2008 024 780 A1 beschreibt ein Leuchtmittel, welches mit mindestens einem Empfänger zum drahtlosen Abgriff von Energie aus einem Wechselfeld ausgerüstet ist und mit mindestens einer Lichtquelle, die mit dem Empfänger zum Abgriff elektrischer Leistung verbunden ist. Ferner wird ein Leuchtmittelträger beschrieben, welcher mit einer Befestigungsfläche zur Befestigung eines solchen Leuchtmittels ausgerüstet ist, wobei der Leuchtmittelträger mindestens einen Sender zur Abstrahlung eines Wechselfelds durch die Befestigungsfläche aufweist. Zudem wird ein System beschrieben, welches mindestens einen Leuchtmittelträger und mindestens zwei Leuchtmittel aufweist, wobei eines der zwei Leuchtmittel einen Schwingkreis mit einer ersten Resonanzfrequenz aufweist und das andere der zwei Leuchtmittel einen Schwingkreis mit einer zweiten Resonanzfrequenz aufweist, wobei sich die erste Resonanzfrequenz und die zweite Resonanzfrequenz unterscheiden.

DE 10 2006 008 345 B3 beschreibt ein Sicherheits- und/oder Wertdokument mit einer elektronischen Transponderschaltung, wobei die Transponderschaltung mit einer Transponderantenne verbunden ist, wobei die Transponderantenne und/oder die Transponderschaltung mit Mitteln zur Anzeige einer Aktivierung der Transponderantenne verbunden ist, welche ein optisches, akustisches oder mechanisches Signal bei oder nach Aktivierung der Transponderantenne erzeugen.

DE 10 2010 028 444 A1 beschreibt ein Dokument mit einem Chip und einer Antenne zur induktiven Einkopplung von Energie, wobei die Antenne eine äußere Windung, zumindest eine mittlere Windung und eine innere Windung aufweist, wobei die mittlere Windung zwischen der äußeren und der inneren Windung angeordnet ist, wobei die mittlere Windung in einem Überbrückungsbereich der Antenne den Chip überbrückt, wobei die innere und die äußere Windung den Chip elektrisch kontaktieren.

Die EP 1 863 093 A2 beschreibt ein organisches lichtemittierendes Bauelement, das ein Substrat, eine auf dem Substrat angeordnete erste Elektrode, einen auf der ersten Elektrode angeordneten Schichtstapel, der mindestens eine Schicht aufweist, die ein organisches Material umfasst und eine auf dem Schichtstapel angeordnete zweite Elektrode umfasst. Der Schichtstapel ist dazu geeignet, im Betrieb elektromagnetische Strahlung zu emittieren. Weiter umfasst das Bauelement eine Empfängervorrichtung, die geeignet ist, Energie aus einem elektromagnetischen Wechselfeld zu entnehmen und zumindest teilweise in elektrische Energie umzuwandeln und dem Schichtstapel zur Verfügung zu stellen.

Die DE 10 2013 207998 A1 beschreibt ein Sicherheits- oder Wertprodukt mit einem passiven, elektrolumineszierenden Sicherheitselement, das ein feldinduziertes elektrolumineszierendes Bauelement umfasst.

Die DE 10 2005 062827 A1 beschreibt ein Dokument mit einem Datenspeicher, einer ersten Antenne zur Datenübertragung auf einer ersten Frequenz, einer Schaltvorrichtung, wobei in einem ersten Schaltzustand der Schaltvorrichtung die Datenübertragung nicht möglich ist und in einem zweiten Schaltzustand der Schaltvorrichtung die Datenübertragung möglich ist, einer zweiten Antenne zum Empfang eines Signals auf einer zweiten Frequenz zur Änderung des Schaltzustands der Schaltvorrichtung, wobei die ersten und zweiten Antennen so ausgebildet sind, dass die ersten und zweiten Frequenzen voneinander beabstandet sind.

Die US 2012/038445 A1 beschreibt einen Transponder mit einem Antennenmodul mit einem Chipmodul und einer Antenne, eine Zusatzantenne mit einer ersten Antennenstruktur in Form einer Flachspule mit einer Anzahl von Windungen, einem äußeren Ende und einem inneren Ende sowie einer zweiten Antennenstruktur in Form einer Flachspule mit einer Anzahl von Windungen, einem äußeren Ende und ein inneres Ende. Das innere Ende der zweiten Antennenstruktur ist mit dem äußeren Ende der ersten Antennenstruktur verbunden. Das Antennenmodul wird so positioniert, dass seine Antenne die erste Antennenstruktur oder die zweite Antennenstruktur überlappt.

Die EP 1 795 915 A2 beschreibt eine Antenne mit einer Richtcharakteristik, welche ein harmonisches Signal empfängt, das von einem Funketikett erzeugt wird. Positionsinformationen, die einer bestimmten Richtung entsprechen, und Empfangsinformationen, die angeben, ob ein harmonisches Signal aus dieser Richtung empfangen wurde oder nicht, werden für jede Richtung eines Bereichs von Richtungen ausgegeben, in die die Antenne gerichtet ist.

Der Erfindung liegt die Aufgabe zugrunde, ein verbessertes LED-Modul zu schaffen, welches sich insbesondere als Sicherheitsmerkmal für die Echtheitsprüfung von Wert- oder Sicherheitsdokumenten oder beweglichen Gütern eignet.

Die der Erfindung zugrunde liegende Aufgabe wird mit den Merkmalen der unabhängigen Patentansprüche gelöst. Ausführungsformen der Erfindung sind in den abhängigen Patentansprüchen angegeben.

Ausführungsformen der Erfindung betreffend ein LED-Modul mit einer Schaltung, die eine LED und einen Schwingkreis zur elektromagnetischen Einkopplung von Energie zum Betrieb der LED aufweist, wobei die Schaltung in dem LED-Modul vollständig gekapselt und anschlusslos ist.

Unter "anschlusslos" wird hier insbesondere verstanden, dass das LED-Modul keine Anschlüsse zur galvanischen Kontaktierung des LED-Moduls aufweist.

Unter "vollständig gekapselt" wird insbesondere verstanden, dass kein Teil der in dem LED-Modul angeordneten Schaltung von außen zerstörungsfrei zugänglich ist.

Nach Ausführungsformen der Erfindung ist also die einzige Möglichkeit, das LED-Modul anzusprechen, eine induktive Einkopplung von Energie in den Schwingkreis. Nur hierdurch kann dieser die LED mit elektrischer Energie versorgen, so dass die LED daraufhin aufleuchtet.

Nach Ausführungsformen der Erfindung handelt es sich bei der LED um eine Organic Light Emitting Diode (OLED).

Nach Ausführungsformen, die nicht Teil der Erfindung sind, wird die Kapazität des Schwingkreises ausschließlich durch die parasitäre Kapazität einer Antenne der Schaltung sowie der Kapazität der LED selbst gebildet, sodass kein zusätzliches Bauelement zur Zurverfügungstellung einer Kapazität für den Schwingkreis erforderlich ist. Dies ermöglicht eine Miniaturisierung der Schaltung.

Nach Ausführungsformen der Erfindung wird die parasitäre Kapazität der Antenne durch mehrere Antennenwindungen gebildet, die auf einem Substrat angeordnet sind, wobei die Breite der Antennenleiterbahn, die die Antennenwindung bildet, sowie der Abstand der Antennenwindungen so gewählt ist, dass sich eine gewünschte Resonanzfrequenz des resultierenden Schwingkreises einstellt.

Nach Ausführungsformen der Erfindung verlaufen auf beiden Seiten einer der Schichten des LED-Moduls Antennenwindungen der Antenne, um die parasitäre Kapazität der Antenne zu erhöhen.

Nach Ausführungsformen, die nicht Teil der Erfindung sind, hat das LED-Modul einen Schichtaufbau, wobei auf einer ersten Schicht eine erste Elektrode zur Kontaktierung der LED und eine Antenne mit mehreren Antennenwindungen, die um die erste Elektrode herum verlaufen, angeordnet sind. Auf die erste Schicht folgt eine zweite Schicht, die die mit der ersten Elektrode kontaktierte LED sowie ein Dielektrikum beinhaltet. Hierauf folgt eine dritte Schicht, die die zweite Elektrode der LED beinhaltet, und die mit der Antenne über ein durch die zweite Schicht hindurchverlaufendes Via elektrisch verbunden ist. Durch die ersten und zweiten Elektroden der LED und dem zwischen den ersten und zweiten Elektroden befindlichen Dielektrikum der zweiten Schicht wird eine Kapazität gebildet, die parallel zu der Kapazität der LED geschaltet ist.

Nach Ausführungsformen der Erfindung trägt eine der Schichten sowohl die erste als auch die zweite Elektrode. Die betreffende Schicht selbst bildet dann das Dielektrikum.

Nach einer Ausführungsform verlaufen die Antennenwindungen entlang eines Randbereichs des LED-Moduls, sodass die Antennenwindungen eine Spulenöffnung bilden, die beispielsweise in einem Zentralbereich des LED-Moduls liegt. Die erste Elektrode kann dann so ausgebildet sein, dass sie diese Spulenöffnung ganz oder teilweise ausfüllt. Die zweite Elektrode kann so ausgebildet sein, dass sie sich über die erste Elektrode erstreckt und diese ganz oder teilweise abdeckt, um eine entsprechend große Kapazität zu schaffen. Die zweite Elektrode hat einen Vorsprung, der den die erste Elektrode überdeckenden Bereich der zweiten Elektrode mit dem Via verbindet, wobei sich der Vorsprung über die Antennenwindungen erstreckt.

Nach Ausführungsformen hat der Schwingkreis des LED-Moduls eine Resonanzfrequenz zwischen 125 kHz bis 2,5 GHz, insbesondere zwischen 10 MHz und 16 MHz, beispielsweise 13,56 MHz, sodass der Schwingkreis durch ein externes elektronisches Gerät, welches einen Primärschwingkreis aufweist, durch induktive Einkopplung von Energie anregbar ist, wobei es sich bei dem externen elektronischen Gerät zum Beispiel um ein Kontaktlos-Lesegerät für Chipkarten, einen Kassenterminal oder ein Mobilfunkgerät, insbesondere ein Mobiltelefon oder Smartphone, handeln kann, welches beispielsweise mit einer RFID- oder NFC-Schnittstelle ausgerüstet ist, welche ein elektromagnetisches Feld, beispielsweise im Bereich von 13,56 MHz abstrahlt.

Nach Ausführungsformen der Erfindung erfolgt der Betrieb des LED-Moduls in einem Fernfeld oder in einem Nahfeld, bevorzugt in einem Nahfeld bei einer Frequenz von 13,56 MHz.

Nach einer Ausführungsform der Erfindung beinhaltet die Schicht ein optisch wirksames Material, um hierdurch das von der LED abgestrahlte Licht zu modulieren, um so ein weiteres Sicherheitsmerkmal zu schaffen. Als optisch wirksames Material kommen beispielsweise die folgenden Stoffe in Frage: fluoreszierende oder phosphoreszierende Stoffe, Farbstoffe zur Filterung des abgegebenen Lichts, Konversionsleuchtstoffe (z.B. upconversion (Lichtfrequenz-Aufwärtskonversion) oder downconversion (Lichtfrequenz-Aufwärtskonversion)) zur Verschiebung des Emissionsspektrums des ausgesendeten Lichtes, Effektpigmente, beispielsweise Metalloxidpartikel, oder retroreflektierende Partikel.

Nach Ausführungsformen der Erfindung werden die folgenden Materialien für die LED verwendet, um verschiedene Farben zu ermöglichen:
Galliumarsenid (GaAs), Aluminiumgalliumarsenid (AIGaAs), Galliumarsenidphosphid (GaAsP), Aluminiumgalliumindiumphosphid (AlGaInP), Galliumphosphid (GaP), Indiumgalliumnitrid (InGaN), Aluminiumgalliumnitrid (AIGaN), Galliumnitrid (GaN)

Bei bevorzugter Verwendung von einer blauen oder einer ultravioletten LED werden Lumineszenzfarbstoffe über der LED angeordnet (z.B. in der Abdeckschicht oder in einem darüber befindlichen Objekt) um weißes, rotes, grünes, gelbes und/oder oranges Licht zu erzeugen.

Ausführungsformen der Erfindung sind besonders vorteilhaft, da das LED-Modul eine Integration in Kunststofffolien, Papier, Textil, Banknoten, Kartendokumente z.B. durch Einlegen oder Einstreuen während der Folienextrusion oder der Papierherstellung ermöglicht, da es eine sehr dünne und kleine Bauform haben kann.

Ausführungsformen der Erfindung sind besonders vorteilhaft, da sie eine Miniaturisierung des LED-Moduls ermöglichen. Ein solches miniaturisiertes LED-Modul kann einen integralen Bestandteil zum Beispiel des Dokumentenkörpers eines Wert- oder Sicherheitsdokuments bilden oder eines beweglichen Guts, um eine bequeme Echtheitsprüfung zu ermöglichen. Besonders vorteilhaft ist dabei, dass für die Echtheitsprüfung meist ohnehin vorhandene elektronische Geräte, wie zum Beispiel Smartphones mit NFC-Schnittstelle oder Kassenterminals verwendet werden können.

Unter einem "Wert- oder Sicherheitsdokument" werden hier papierbasierte und/oder kunststoffbasierte Dokumente verstanden, wie zum Beispiel Ausweisdokumente oder andere ID-Dokumente, insbesondere Reisepässe, Personalausweise, Visas sowie Führerscheine, Fahrzeugscheine, Fahrzeugbriefe, Firmenausweise, Gesundheitskarten oder andere ID-Dokumente sowie auch Chipkarten, Zahlungsmittel, insbesondere Bankkarten und Kreditkarten, Frachtbriefe, Geschenk- oder Einkaufsgutscheine oder sonstige Berechtigungsnachweise, Steuerzeichen, Postwertzeichen, Ticket, (Spiel) Jetons oder Haftetiketten.

Das Wert- oder Sicherheitsdokument kann im ID 1-, ID 2-, ID 3- oder in irgendeinem anderen Format vorliegen, beispielsweise in Heftform, wie bei einem pass-ähnlichen Gegenstand. Ein Wert- oder Sicherheitsdokument ist im Allgemeinen ein Laminat aus mehreren Dokumentenlagen, die passergenau unter Wärmeeinwirkung und unter erhöhtem Druck flächig miteinander verbunden sind. Alternativ können diese Dokumente auch durch Spritzgießen oder Extrudieren hergestellt werden. Die Dokumente können den normierten Anforderungen genügen, beispielsweise ISO/IEC 10373, 7810, 14443. Die Dokumentenlagen bestehen vorzugsweise aus einem Dokumententrägermaterial, das sich für eine Lamination eignet.

Ausführungsformen der Erfindung sind besonders vorteilhaft, da ein oder mehrere der LED-Module aufgrund der Miniaturisierung in Papier, Kunststoff oder textile Materialien integriert oder aufgebracht werden können.

Nach Ausführungsformen der Erfindung werden die LED-Module bei der Papierherstellung zum Beispiel in den Papierbrei oder den Faserbrei eingestreut oder der Papierbahn zugegeben, solange diese noch einen hohen Wassergehalt von zum Beispiel mehr als 8 % aufweist. Dadurch erhält man ein Papier, in dem erfindungsgemäße LED-Module vollständig eingebettet sein können. Ein solches Papier eignet sich besonders für die Weiterverarbeitung zu einem Wert- oder Sicherheitsdokument, insbesondere einer Banknote.

Nach einer Ausführungsform der Erfindung werden ein oder mehrere LED-Module bei der Herstellung eines Kunststoffteils dem plastifizierten Kunststoff zugegeben, aus dem das Kunststoffteil hergestellt werden soll. Dies kann beispielsweise in einem Extrusionsprozess oder in einem Kunststoffspritzgussprozess erfolgen. In diesem Fall erhält man ein Kunststoffteil, welches ein oder mehrere der LED-Module als integralen Bestandteil beinhaltet.

Nach einer Ausführungsform der Erfindung werden die LED-Module dem plastifizierten Kunststoff vor einer Folienextrusion zugegeben, sodass man eine Kunststofffolie mit den eingebetteten LED-Modulen erhält. Eine solche Kunststofffolie kann zum Beispiel für die Herstellung einer Chipkarte weiterverarbeitet werden, wobei dann eine Schicht der Chipkarte, die aus einer solchen Folie hergestellt worden ist, ein oder mehrere der LED-Module beinhalten kann.

Nach Ausführungsformen der Erfindung wird ein LED-Modul, das für die Integration in Papier, insbesondere ein Banknotenpapier, vorgesehen ist, zunächst beschichtet, wie zum Beispiel durch Tauchen oder Spulen. Für die Beschichtung kommen beispielsweise die folgenden Materialien infrage: thermoplastische Urethane oder Elastomere (TPU, TPE) oder latent reaktive Klebstoffe, wie zum Beispiel Isocyanate. Das so beschichtete LED-Modul wird vor Aushärtung des Urethans, Elastomers bzw. des latent reaktiven Klebstoffs bei der Papierherstellung zugegeben und härten dann beim Trocknen der Papierbahn aus, sodass eine besonders innige Verbindung mit dem umgebenden Papiermaterial gegeben ist. Ferner wird hierdurch eine lokale Versteifung des Papiermaterials und damit ein erhöhter mechanischer Schutz des LED-Moduls erzeugt.

Nach einer weiteren Ausführungsform der Erfindung kann ein LED-Modul auf ein Wert- oder Sicherheitsdokument, wie zum Beispiel eine Banknote oder eine Chipkarte, zusammen mit einer Folienapplikation, wie zum Beispiel einem Hologrammstreifen oder einem Fenster, aufgebracht werden.

Nach einer weiteren Ausführungsform betrifft die Erfindung ein Schmuckstück, in welches ein oder mehrere erfindungsgemäße LED-Module integriert sind. Dies kann zu dem Zweck einer Echtheitsprüfung des Schmuckstücks dienen und/oder als dekoratives Element oder optischer Sender.

Wenn beispielsweise der Träger des Schmuckstücks ein übliches Smartphone mit einer NFC-Schnittstelle bei sich führt, so kann die NFC-Schnittstelle von einem Anwendungsprogramm, das heißt einer sogenannten App, des Smartphones angesteuert werden, um den Schwingkreis des LED-Moduls permanent oder situationsabhängig anzusteuern. Beispielsweise erfolgt eine Ansteuerung durch die App nur dann, wenn sich der Nutzer an bestimmten geografischen Positionen befindet, die von dem Smartphone beispielsweise mithilfe einer GPS-Funktionalität bestimmt werden oder wenn das Smartphone sensiert, dass sich beispielsweise das Smartphone eines anderen Nutzers in der Nähe befindet.

Die mindestens eine Antennenleiterbahn kann in einer Ausführungsform der vorliegenden Erfindung mittels einer Leitpaste oder Leitfarbe auf eine der Schichten gedruckt werden. Vorzugsweise ist die Antennenleiterbahn als Druckschicht mit elektrisch leitenden Pigmentpartikeln ausgebildet. Die Antennenleiterbahn kann mittels üblicher Drucktechniken auf den Anzeigeträger des Anzeigemoduls aufgebracht werden. Die Dicke der aufgedruckten Paste oder des Lacks kann insbesondere 1 µm bis 100 µm und besonders bevorzugt etwa 10 µm betragen.

Die Leitpaste oder der Leitlack kann entweder einfach getrocknet werden oder mittels Wärme und/oder Bestrahlung mit elektromagnetischer Strahlung, beispielsweise UV-Strahlung, aushärtbar sein. Die Leitpaste oder Leitfarbe enthält mindestens ein Polymer als Binder sowie mindestens ein Metall und/oder ein leitfähiges Metalloxid und/oder anderes leitfähiges Material in dem Polymer.

Als leitfähiges Material kommen Kupfer, Silber, Gold, Eisen, Zink, Zinn oder Kohlenstoff, insbesondere Graphit, Singlewall- und/oder Multiwall-Nanotubes, Fullerene oder Graphene in Betracht. Als Metalloxide kommen ITO (Indium-Zinn-Oxid), IZO, FTO (Fluor-dotiertes Zinndioxid), ATO (Antimonoxid) in Betracht. Die Metalle/Metalloxide können in Form von Flakes, Nadeln, Pulver (insbesondere nanoskalig), Plättchen oder dergleichen vorliegen. Insbesondere liegen diese als aggregierte Partikel vor. Als andere leitfähige Materialien kommen leitfähige organische Materialien/Polymere, z.B. Polyanilin, PEDOT:PSS, in Betracht. Beispiele für geeignete Materialien zum Herstellen der Antennenleiterbahn sind Produkte der Firma Nano-Chemonics, NM, USA. Weitere Beispiele geeigneter Tinten bzw. Beschichtungsmittel sind die Produkte IJAg-150-Fx oder AG-IJ-G-100-51 (Silberbasis mit Partikeldurchmesser zwischen 30 und 50 nm), welche mittels Tintenstrahldruck aufbringbar sind. Diese Beschichtungsmittel zeichnen sich zudem dadurch aus, dass eine Leitschicht erst durch einen Aktivierungsschritt, z.B. Laserbestrahlung mit 500 bis 580 nm, im Wege der Sinterung der Partikel entsteht. Die an sich nicht leitfähige Schicht wird mit der Bestrahlung hoch leitfähig. Schließlich sind Siebdruckfarben mit leitfähigen Partikeln der Firmen Dupont (5028 oder 5029) und Spraylat einsetzbar, welche durch Wärmeeinwirkung ihre Leitfähigkeit erhöhen, insbesondere vervielfachen oder Strukturierungstechniken, wie sie an sich aus der Halbleiterfertigung bekannt sind.

Insbesondere kann die Antennenleiterbahn in einer Ätztechnik aus Aluminium oder Kupfer mittels eines Ätzresists oder in einem Pattern-Plating-Verfahren hergestellt werden. Bei Pattern-Plating-Verfahren werden, ausgehend von einer Grundmetallisierung, beispielsweise aus Kupfer, mit einem Platingresist auf der Grundmetallisierung zunächst die Strukturen als Kanäle geformt. Dann wird zusätzliches Metall in den Kanälen galvanotechnisch abgeschieden. Nach dem Entfernen des Platingresists wird die Grundmetallisierung zwischen den Strukturen durch Ätzen oder mittels Laser direct imaging (LDI) oder Laserablation oder Fräsen entfernt. Als Substratmaterialien kommen unter anderem FR4, Polyimid und PC in Betracht.

Nach Ausführungsformen der Erfindung ist das Wert- oder Sicherheitsdokument ist, wie oben angegeben, durch einen Dokumentenkörper aus einer oder mehreren Lagen aus thermoplastisch verarbeitbaren Kunststoffen gebildet, wobei die oben angegebenen Polymere die thermoplastisch verarbeitbaren Kunststoffe sind. Dieses Ensemble wird dann mit weiteren äußeren Polymerlagen, die die zentralen Polymerlagen und das Anzeigemodul an der Oberseite und an der Unterseite abschließen, kollationiert. Abschließend wird der Stapel durch Laminieren zu einem monolithischen Block verbunden. Hierzu kann ein Wert- oder Sicherheitsdokument in einer Heiz-Kühl-Presse bei einer Temperatur bis zu etwa 200°C und bei einem Druck von etwa 300 bis 500 N/cm² im Heizpresszyklus und etwa 500 bis 700 N/cm² im Kaltpresszyklus hergestellt werden. Diese Werte gelten für Dokumente aus Polycarbonat. Für andere Materialien werden angepasste Temperaturen eingesetzt. Auf die sich an der Oberseite befindende äußere Polymerlage, d.h. die Abdeckschicht, kann in einer alternativen Ausführungsform auch verzichtet werden. In diesem Falle wird der laminierte Dokumentenrohling dann mit einem Schutzlack versehen.

In einem weiteren Aspekt betrifft die Erfindung ein elektronisches System mit einem elektronischen Gerät und zumindest einem LED-Modul, welches zu einem Wert- oder Sicherheitsdokument oder einem anderen beweglichen Gut, wie zum Beispiel einem Schmuckstück, gehören kann. Durch das elektronische Gerät, wie zum Beispiel einem Kassenterminal oder einem Smartphone, wird vorzugsweise durch induktive Einkopplung von elektrischer Energie seitens des Primärschwingkreises des elektronischen Geräts in den Schwingkreis des LED-Moduls das Aufleuchten der LED ausgelöst, sodass hierdurch eine Echtheitsprüfung und/oder ein dekorativer Effekt gegeben ist.

Nach einer Ausführungsform der Erfindung handelt es sich bei dem beweglichen Gut um ein textiles Produkt, wie z.B. ein Kleidungsstück, ein elektronisches Gerät, wie zum Beispiel einen Computer, ein Maschinenteil,
ein Ersatzteil, ein Medikament oder ein hochwertiges Getränk oder auch eine Verpackung oder Behälter für ein wertvolles oder sicherheitsrelevantes Produkt. Durch Anwendung von Ausführungsformen des erfindungsgemäßen Systems
kann sich zum Beispiel ein potentieller Endverbraucher des Guts von dessen Authentizität vor dem Kauf überzeugen. Ferner können
sich auch zum Beispiel Zwischenhändler, Handelsketten und dergleichen, die ein solches Gut gegenüber dem Endverbraucher anbieten möchten, Sicherheit hinsichtlich der Echtheit der von ihnen angebotenen Güter verschaffen.

Nach Ausführungsformen der Erfindung ist das elektronische Gerät so ausgebildet, dass es die Validität des LED-Moduls prüft, vorzugsweise bevor durch das elektronische Gerät Energie zum Betrieb der LED in das LED-Modul eingekoppelt wird. Damit das LED-Modul als valide betrachtet werden kann, muss eine Eigenschaft der Schaltung geprüft werden.

Bei dieser Eigenschaft der Schaltung kann es sich zum Beispiel um die Resonanzfrequenz der Schaltung handeln. Die Resonanzfrequenz kann indirekt geprüft werden, indem das elektronische Gerät einen Impuls an das LED-Modul sendet, worauf das LED-Modul mit einer Impulsantwort antwortet. Diese Impulsantwort hängt von der Übertragungsfunktion des LED-Moduls und damit auch von dessen Resonanzfrequenz ab.
Das Lesegerät vergleicht die von dem LED-Modul empfangene Impulsantwort mit ersten Referenzdaten. Bei hinreichender Übereinstimmung der empfangenen Impulsantwort mit den ersten Referenzdaten gilt das LED-Modul als valide und das elektronische Gerät steuert dann seinen Primärschwingkreis an, um mit der Resonanzfrequenz des LED-Moduls Energie in das LED-Modul einzukoppeln. Hierdurch wird auch bei höheren Frequenzen ein hoher Kopplungsfaktor zwischen dem elektronischen Gerät und dem LED-Modul realisiert, sodass in dem LED-Modul hinreichend Energie zum Betrieb der LED eingekoppelt wird.

Hierdurch wird die Sicherheit weiter erhöht, da erst nach Prüfung der Validität des LED-Moduls die LED aufleuchten kann.

Nach einer Ausführungsform der Erfindung wird das von der LED abgestrahlte Licht mit einem optischen Sensor erfasst. Das sensierte Licht wird beispielsweise hinsichtlich seiner spektralen Zusammensetzung mit zweiten Referenzdaten verglichen. Bei hinreichender Übereinstimmung des sensierten Lichts mit den zweiten Referenzdaten wird von dem elektronischen Gerät ein Signal erzeugt, das die Übereinstimmung anzeigt.

Nach einer Ausführungsform der Erfindung wird ein Smartphone oder Tablet-PC als elektronisches Gerät verwendet. Hierbei bildet die RFID- oder NFC-Schnittstelle des Smartphones oder Tablet-PC den Primärschwingkreis. Besonders vorteilhaft ist, wenn das LED-Licht mit der Kamera des Smartphones oder Tablet-PCs erfasst wird, da dann kein zusätzliches Gerät erforderlich ist. Die Ansteuerung des Primärschwingkreises sowie auch die Ausgabe des die Validität anzeigenden Signals bei hinreichender Übereinstimmung des sensierten Lichts mit den Referenzdaten kann durch ein Anwendungsprogramm, das heißt eine sogenannte App, die auf dem Smartphone bzw. dem Tablet-PC installiert ist, erfolgen.

Im Weiteren werden Ausführungsformen der Erfindung mit Bezugnahme auf die Zeichnungen näher erläutert. Es zeigen:
- Figur 1: eine Ausführungsform eines erfindungsgemäßen elektronischen Systems,
- Figur 2: eine Draufsicht einer Ausführungsform eines LED-Moduls, die nicht Teil der Erfindung ist,
- Figur 3: eine Schnittansicht der Ausführungsform gemäß Figur 2,
- Figur 4: eine Explosionszeichnung einer Ausführungsform eines erfindungsgemäßen Schmuckstücks,
- Figur 5: eine Schnittansicht einer Ausführungsform eines erfindungsgemäßen Papiers, Kunststoffs oder textilen Materials.
- Figur 6: eine Draufsicht einer alternativen Ausführungsform eines erfindungsgemäßen LED-Moduls,
- Figur 7: eine Schnittansicht der Ausführungsform gemäß Figur 6,
- Figur 8: eine Draufsicht einer alternativen Ausführungsform eines erfindungsgemäßen LED-Moduls,
- Figur 9: eine Schnittansicht der Ausführungsform gemäß Figur 8.

Elemente der nachfolgenden Ausführungsformen, die einander entsprechen oder gleichen werden jeweils mit denselben Bezugszeichen gekennzeichnet.

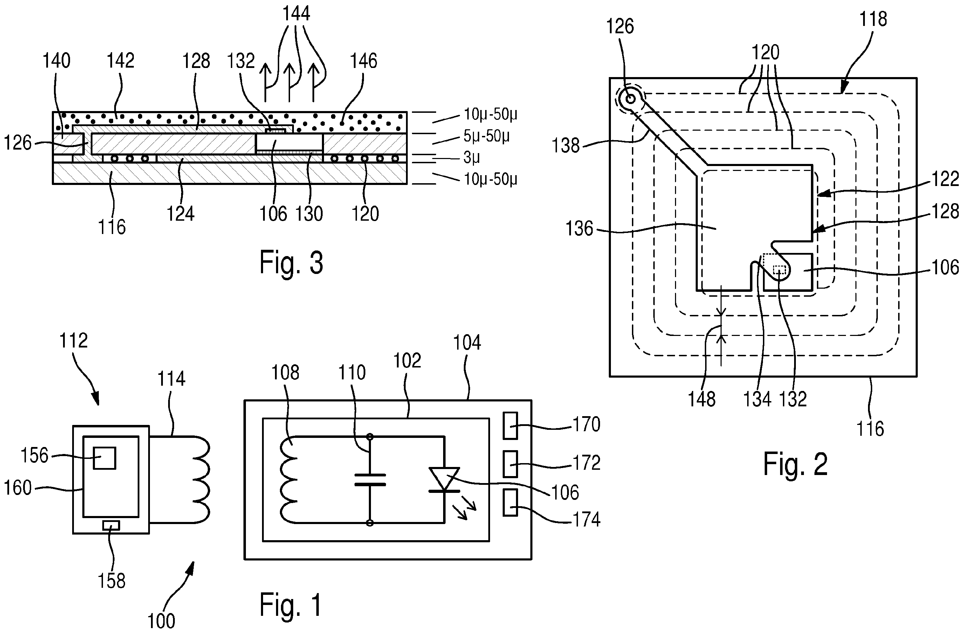

Die Figur 1 zeigt eine Ausführungsform eines erfindungsgemäßen elektronischen Systems 100. Das elektronische System 100 beinhaltet zumindest ein LED-Modul 102, welches in oder an einem beweglichen Gut 104 angeordnet sein kann. Das LED-Modul beinhaltet eine Schaltung mit einer LED 106 und einem Schwingkreis, der durch eine Induktivität 108 und eine Kapazität 110 gebildet wird, wobei die Kapazität 110 hier parallel zu der LED 106 geschaltet ist, sodass die Gesamtkapazität des Schwingkreises durch die Summe der Kapazität 110 und der Kapazität der LED 106 gegeben ist. Durch diese Gesamtkapazität und die Induktivität 108 wird die Resonanzfrequenz des Schwingkreises bestimmt.

Die Schaltung ist in dem LED-Modul 102 vollständig gekapselt und anschlusslos. Die einzige Möglichkeit zur Ansteuerung des LED-Moduls ist eine induktive Einkopplung von Energie in den Schwingkreis, sodass die LED 106 aufleuchtet. Hierzu hat das elektronische System 100 ein elektronisches Gerät 112, das über Felderzeugungsmittel, das heißt einen Primärschwingkreis 114, verfügt, um den Schwingkreis des LED-Moduls 102 anzuregen. Vorzugsweise ist der Primärschwingkreis 114 auf den Schwingkreis des LED-Moduls 102 abgestimmt, das heißt die Anregung bei der Resonanzfrequenz erfolgt.

Beispielsweise kann es sich bei dem elektronischen Gerät 112 um einen Kassenterminal handeln, wie er zum Beispiel im Einzelhandel, wie zum Beispiel in einem Supermarkt, verwendet wird. Wenn es sich bei dem beweglichen Gut 104 zum Beispiel um ein Zahlungsmittel, wie zum Beispiel eine Banknote oder eine Chipkarte, handelt, so kann an dem Kassenterminal eine Echtheitsprüfung erfolgen, indem der Kassenterminal elektrische Energie in den Schwingkreis einkoppelt, sodass das Aufleuchten der LED die Echtheit signalisiert.
Bei dem elektronischen Gerät kann es sich auch um ein Mobilfunkgerät, wie zum Beispiel ein sogenanntes Smartphone, mit einer RFID- oder NFC-Schnittstelle handeln, die die Funktion des Primärschwingkreises 114 realisiert. Alternativ kann es sich bei dem elektronischen Gerät 112 auch um ein kontaktloses Chipkartenterminal, beispielsweise mit einer NFC- und/oder RFID-Schnittstelle handeln.

Das LED-Modul 102 kann eine miniaturisierte Bauform aufweisen. Beispielsweise kann die Dicke des LED-Moduls 102 zwischen 30 µm und 5000 µm betragen und es kann laterale Abmessungen von zum Beispiel 500 µm • 500 µm bis zu 3 mm • 3 mm aufweisen.

Bei dem elektronischen Gerät 112 kann es sich beispielsweise um ein batteriebetriebenes tragbares Gerät, wie zum Beispiel ein Smartphone oder einen Tablet-PC, handeln. Auf dem elektronischen Gerät 112 ist ein Anwendungsprogramm, das heißt eine sogenannte App 156, installiert, die ein Nutzer über eine Nutzerschnittstelle des elektronischen Geräts, wie zum Beispiel ein berührungssensitives Display, das heißt einen sogenannten Touchpanel 160, starten kann. Ferner kann das elektronische Gerät 112 über einen optischen Sensor, wie zum Beispiel eine Kamera 158, verfügen.

Zur Prüfung des LED-Moduls 102 wird beispielsweise wie folgt vorgegangen:
1. Der Nutzer startet die App 156. Daraufhin steuert die App 156 den Primärschwingkreis 114 zum Senden eines Impulses an. Hierbei kann es sich um einen sogenannten Einheitsimpuls handeln, der auch als Dirac-Impuls bezeichnet wird.
2. Das LED-Modul 102 empfängt mit seiner Antenne 118 den Impuls von dem elektronischen Gerät 112. Die Schaltung des LED-Moduls 102 antwortet auf diesen Impuls mit einer Impulsantwort, die für die Übertragungsfunktion und damit für die Resonanzfrequenz des LED-Moduls 102 charakteristisch ist. Diese Impulsantwort wird von der Antenne 118 gesendet und von dem elektronischen Gerät 112 mithilfe des Primärschwingkreises 114 empfangen.
3. Das elektronische Gerät 112 hat einen Speicher, in dem erste Referenzdaten für die Impulsantwort gespeichert sind. Die App 156 greift auf diesen Speicher zu, um die Referenzdaten zu lesen und die empfangene Impulsantwort auf Übereinstimmung mit den Referenzdaten zu prüfen. Für den Fall, dass eine hinreichende Übereinstimmung vorliegt, steuert die App 156 den Primärschwingkreis 114 so an, dass dieser den Schwingkreis des LED-Moduls 102 mit dessen Resonanzfrequenz anregt.
4. Die App 156 steuert dann die Kamera 158 an, sodass das von der LED 106 aufgrund der Einkopplung der Energie abgestrahlte Licht sensiert wird.
5. In dem Speicher des elektronischen Geräts 112 sind zweite Referenzdaten für das sensierte Licht gespeichert. Die App 156 greift auf diese Referenzdaten zu, um das sensierte Licht mit den Referenzdaten zu vergleichen. Bei hinreichender Übereinstimmung gilt das LED-Modul 102 als valide und die App 156 generiert ein entsprechendes Signal, welches zum Beispiel als optisches Signal auf dem Touchpanel 160 und/oder als akustisches und/oder als haptische Signal, das heißt als Vibrationssignal, von dem elektronischen Gerät 112 ausgegeben wird, sodass der Nutzer über die erfolgreiche Prüfung der Validität des LED-Moduls 102 informiert wird.

Bei dem bewegliche Gut 104 kann es sich um ein Wert- oder Sicherheitsdokument handeln. Das bewegliche Gut 104 kann einen geschützten Datenspeicher 170 aufweisen, in dem z.B. persönliche Daten eines Nutzers gespeichert sind, wie es z.B. bei einem elektronischen Personalausweis der Bundesrepublik Deutschland der Fall ist. Das bewegliche Gut 104 kann ferner einen Prozessor 172 aufweisen, der dazu konfiguriert ist, einen externen Zugriff auf den Datenspeicher 170 über Kommunikationsschnittstelle 174 nur dann zuzulassen, wenn ein kryptografisches Protokoll zur Authentifizierung und/oder Berechtigungsprüfung eines externen Lesegeräts, z.B. des elektronischen Geräts 112, erfolgreich durchgeführt worden ist. Hierbei kann es sich z.B. um eine sog. basic access control (BAC) und/oder eine extended access control (EAC) handeln. Die Kommunikationsschnittstelle 174 kann als kontaktlose Schnittstelle ausgebildet sein, beispielsweise als RFID oder NFC Schnittstelle. Das LED-Modul ist weder mit dem Prozessor 172 noch mit der Kommunikationsschnittstelle 174 elektronisch verbunden.

Die Figur 2 zeigt eine Draufsicht auf eine Ausführungsform eines LED-Moduls 102, die nicht Teil der Erfindung ist. Das LED-Modul 102 hat ein Substrat 116, beispielsweise aus Keramik oder Kunststoff, wie zum Beispiel Polyimid oder Polyamid. Auf dem Substrat 116 ist eine Antenne 118 angeordnet, indem eine Antennenleiterbahn 120 in mehreren Windungen auf dem Substrat 116 angeordnet ist.

Die Windungen der Antennenleiterbahn 120 verlaufen entlang eines Randbereichs des Substrats, sodass hierdurch eine Antennenspule gebildet wird, die in einem Zentralbereich des Substrats 116 eine Spulenöffnung 122 hat. Im Bereich dieser Spulenöffnung 122 ist eine Elektrode 124 (vergleiche Figur 3, die nicht Teil der Erfindung ist) der LED 106 angeordnet.

Die Elektrode 124 füllt die Spulenöffnung 122 auf dem Substrat 116 ganz oder teilweise aus. Ein erstes Ende der Antennenleiterbahn 120 ist mit der Elektrode 124 elektrisch verbunden. Das andere Ende der Antennenleiterbahn 120 ist über ein Via 126 mit einer zweiten Elektrode 128 der LED 106 elektrisch verbunden.

Beispielsweise hat die LED 106 einen ersten Höcker 130 zur Verbindung mit der Elektrode 124 und einen zweiten Höcker 132, der vorzugsweise am Rand der LED 106 angeordnet ist, um eine möglichst große Austrittsfläche für die Abstrahlung zur Verfügung zu stellen, wobei der zweite Höcker 132 zur elektrischen Verbindung mit der zweiten Elektrode 128 dient.

Die zweite Elektrode 128 hat einen ersten Vorsprung 134, der sich innerhalb der Spulenöffnung 122 erstreckt, um die zweite Elektrode 128 mit dem Höcker 132 elektrisch zu verbinden. Die zweite Elektrode 128 hat ferner einen flächigen Bereich 136, der sich über die Spulenöffnung 122 erstreckt und diese und die darunter befindlich erste Elektrode 124 ganz oder teilweise überdeckt. Ferner hat die Elektrode 128 einen zweiten Vorsprung 138, der den flächigen Bereich 136 mit dem Via 126 verbindet, wobei sich der Vorsprung 138 über die von der Antennenleiterbahn 120 gebildeten Antennenwindungen erstreckt.

Durch das Substrat 116 wird bei der hier betrachteten Ausführungsform eine erste Schicht des LED-Moduls 102 gebildet. Die darauffolgende zweite Schicht 140 beinhaltet neben der LED 106 ein Dielektrikum, das heißt ein Material mit hoher Dielektrizitätszahl, wie zum Beispiel Benzocylcobuten (BCB) oder ein anderes Polymer, das mit anorganischen Substanzen gefüllt ist, wie zum Beispiel Ormocere und/oder anorganische Substanzen wie Titandioxid, Bariumtitanat oder Bleizirkoniumtitanat.

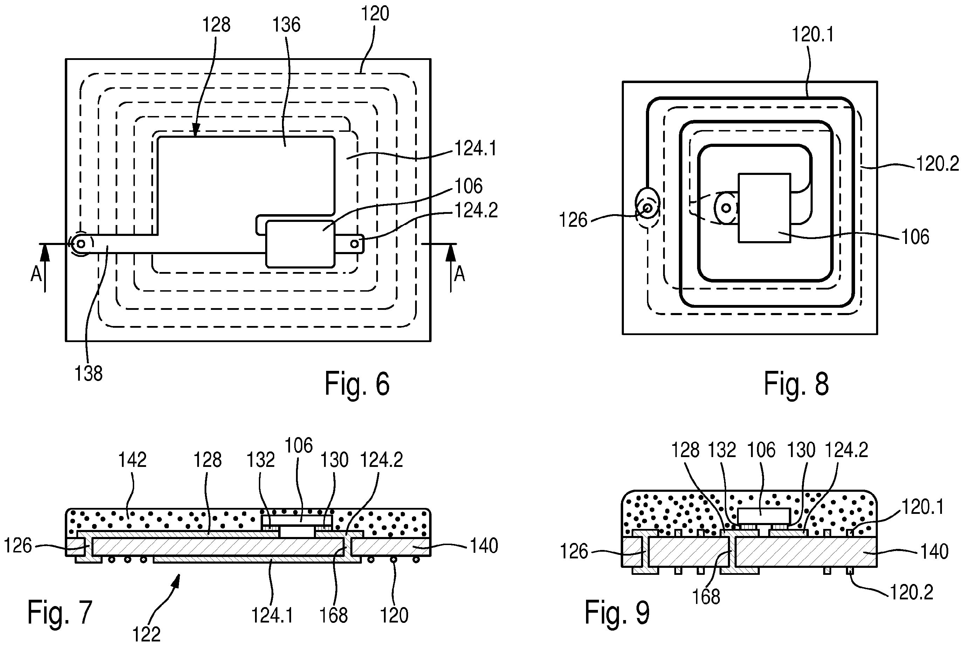

In einer alternativen Ausführungsform (vgl. Ausführungsform der Fig. 6, 7 und 8, 9), kann das Substrat 116 selbst als Dielektrikum fungieren, wobei sich dann die Elektrode 124 und die Antennenleiterbahn 120 auf der einen Seite des Substrats und die Elektrode 128 auf der gegenüberliegenden Seite des Substrats befindet und das Via 126 durch das Substrat hindurchverläuft, wobei die LED 106 je nach Ausführungsform auf der einen oder auf der anderen Seite des Substrats oder in einer Kavität oder einer Öffnung des Substrats angeordnet sein kann.

Gemäß der Ausführungsform nach Figur 2 und Figur 3, die nicht Teil der Erfindung sind, folgt auf die zweite Schicht 140 eine dritte Schicht 142, nämlich eine Abdeckschicht, die das LED-Modul 102 nach außen abschließt und insbesondere die Elektrode 128 und die LED 102 überdeckt. Hierdurch wird das LED-Modul 102 vollständig nach außen hin gekapselt, sodass keine der Komponenten der in dem LED-Modul gebildeten Schaltung von außen her zugänglich sind, ohne das LED-Modul zu zerstören, außer indem kontaktlos induktiv Energie in den Schwingkreis der Schaltung eingekoppelt wird.

Das Substrat 116 hat beispielsweise eine Dicke von 10 µm bis 50 µm. Die auf das Substrat 116 aufgebrachte Metallisierungsschicht, durch welche insbesondere die Elektrode 124 und Antennenleiterbahn 120 gebildet werden, hat eine Dicke von zum Beispiel 1 bis 6 µm, beispielsweise 3 µm. Die darauffolgende Schicht 140 mit dem Dielektrikum und der LED 102 hat eine Dicke von beispielsweise 5 µm bis 50 µm und die Abdeckschicht, das heißt die Schicht 142, hat eine Dicke von zum Beispiel 10 µm bis 50 µm.

Die Schicht 142 kann zum Beispiel aus einem Epoxidmaterial bestehen. Die Schicht 142 kann ferner zumindest in dem Bereich des Lichtpfades des von der LED 106 abgestrahlten Licht 144 ein oder mehrere optisch wirksame Materialien 146 beinhalten, die zur Realisierung eines zusätzlichen Sicherheitsmerkmals und/oder dekorativen Effekts dienen und/oder das abgestrahlte Licht 144 mit einer zusätzlichen Information versehen können.

Die Herstellung des LED-Moduls 102 kann mit an sich bekannten Strukturierungstechniken erfolgen.

Durch die einander gegenüberliegenden Elektroden 124 und 128 und das dazwischen befindliche Dielektrikum der Schicht 140 wird eine Kapazität gebildet, die in die Kapazität 110 eingeht. In diese Kapazität 110 geht ferner auch die parasitäre Kapazität der Antenne 118 ein, die hauptsächlich durch die parallel zueinander verlaufenden Antennenwindungen der Antennenleiterbahn 120 verursacht wird.

Je nach Ausführungsform kann die parasitäre Kapazität der Antenne 118 zur Erreichung einer gewünschten Resonanzfrequenz des Schwingkreises des LED-Moduls 102 ausreichend sein, sodass auf den flächigen Bereich 136 ganz oder teilweise verzichtet werden kann. In diesem Fall wird eine weitere Miniaturisierung des LED-Moduls 102 ermöglicht.

Wenn die Breite der Antennenleiterbahn 120 beispielsweise 10 µm beträgt und der Abstand 148 zwischen zwei benachbarten Windungen der Antennenleiterbahn 120 beispielsweise 10 µm beträgt und die Fläche des Substrats 116 beispielsweise 2 mm • 2 mm beträgt, so ergibt sich daraus bei einer Anzahl von 40 Antennenwindungen eine Induktivität 108 von 1,8 µH, sodass eine Kapazität 110 von 76 pF erforderlich ist, um auf eine gewünschte Resonanzfrequenz von 13,56 MHz zu kommen. In diesem Fall ist die Ausbildung der Elektrode 128 mit dem flächigen Bereich 136 bevorzugt, um diese Gesamtkapazität 110 zu erreichen.

Hat hingegen das Substrat 116 lediglich eine Größe von beispielsweise 3 mm • 3 mm und verkleinert man die Breite der Antennenleiterbahn 120 auf beispielsweise 5 µm sowie den Abstand 148 auf 5 µm, so ergibt sich bei einer Windungszahl von 46 eine Induktivität von 10,6 µH. In diesem Fall reicht die parasitäre Kapazität der Antenne 118 zusammen mit der Kapazität der LED 106, die beispielsweise 13 pF beträgt, aus, um den Schwingkreis des LED-Moduls 102 auf die Resonanzfrequenz von 13,56 MHz zu bringen.

Nach weiteren Ausführungsformen der Erfindung ist es möglich, die Schaltung des LED-Moduls 102 mit mehr als einer LED, zum Beispiel antiparallelen LEDs, zu versehen, um hierdurch eine höhere Kapazität 110 bei einer kleineren Antennenspule zu schaffen, um dadurch noch kleinere Außenabmessungen des LED-Moduls 102 zu ermöglichen.

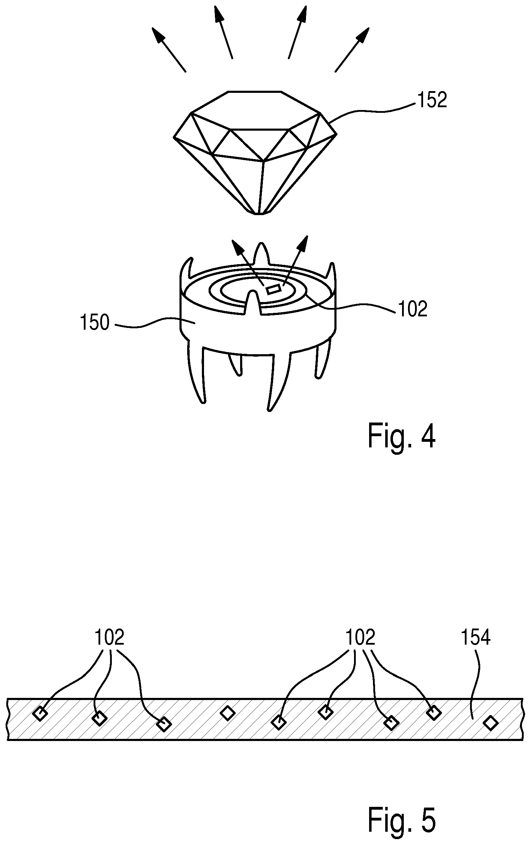

Die Figur 4 zeigt eine Ausführungsform eines erfindungsgemäßen Schmuckstücks mit einer Fassung 150 für ein Schmuckelement 152, wie zum Beispiel einem Kristall, z.B. ein geschliffener Kristallglasstein, einen Edelstein oder Halbedelstein, eine Perle oder ein anderes dekoratives Element. An dem Schmuckelement 152 oder der Fassung 150 ist zumindest ein LED-Modul 102 angeordnet.

Beispielsweise ist das Schmuckelement 152 transparent oder teiltransparent ausgebildet, sodass von dem LED-Modul 102 ausgestrahltes Licht durch das Schmuckelement 152 hindurchtreten kann, sodass das Schmuckelement 152 aufleuchtet, wenn Energie in das LED-Modul 102 induktiv eingekoppelt wird. In diesem Fall ist das LED-Modul 102 vorzugsweise unterhalb des Schmuckelements 152 in der Fassung 150 angeordnet, die beispielsweise als Krallenfassung ausgebildet sein kann. Alternativ erfolgt die Fixierung des Schmuckelements 152 durch Kleben oder Magnethalterung.

Die Figur 5 zeigt einen Querschnitt durch eine Materialschicht 154. Bei der Materialschicht 154 kann es sich zum Beispiel um ein Papier, insbesondere für die Herstellung von Banknoten oder anderen Wert- oder Sicherheitsdokumenten handeln. In der Materialschicht 154 befinden sich mehrere verteilt angeordnete LED-Module 102, die vollständig in der Materialschicht 154 eingebettet sind. Dies kann dadurch erreicht werden, dass bei der Papierherstellung dem Faserbrei oder der noch nicht oder nicht vollständig getrockneten Papierbahn die LED-Module 102 zugegeben werden. Vorzugsweise werden die LED-Module 102 zuvor mit einem Kleber beschichtet, der nach der Zugabe zu dem Faserbrei bzw. der Papierbahn aushärtet, um so eine besonders innige Vereinigung mit dem umgebenden Papier zu bilden.

Bei der Materialschicht 154 kann es sich zum Beispiel auch um einen Kunststoff, insbesondere eine Kunststofffolie, handeln, wie sie ebenfalls bei der Herstellung von Wert- oder Sicherheitsdokumenten, insbesondere der Herstellung von Chipkarten, Verwendung findet. In diesem Fall werden zur Herstellung der Materialschicht 154 dem bereits pastifizierten Kunststoff die LED-Module 102 zugegeben, um anschließend durch einen Kunststoffspritzguss- oder Extrusionsschritt die Materialschicht 154 zu formen, die dann mit den darin eingeschlossenen LED-Modulen 102 erstarrt.

Bei der Materialschicht 154 kann es sich auch um die Wandung eines Bauteils handeln, wie zum Beispiel die Wandung eines beweglichen Gutes, insbesondere zum Beispiel eines beweglichen Gutes, das ganz oder teilweise aus Kunststoff besteht, beispielsweise einer Getränkeflasche oder eines Schmuckstücks.

Die Figuren 6 und 7 zeigen eine Ausführungsform der Erfindung, bei der die Anschlüsse der LED 106, das heißt die Höcker 130 und 132, auf derselben Seite der LED 106 angeordnet sind. Bei dieser Ausführungsform wird die erste Elektrode 124 durch die beiden Elektrodenabschnitte 124.1 und 124.2 gebildet, die miteinander über ein Via 168 verbunden sind, welches durch die Schicht 140 hindurchverläuft. Dabei befindet sich der Antennenabschnitt 124.1 innerhalb der Spulenöffnung 122 und füllt diese ganz oder teilweise aus, sowie es auch nach den Ausführungsformen gemäß Figuren 2, 3, die nicht Teil der Erfindung sind, der Fall ist. Durch die einander gegenüberliegenden Elektrode 128 und den Elektrodenabschnitt 124.1 mit der dazwischenliegenden Schicht 140, die ein Dielektrikum bildet, wird eine Kapazität gebildet, die in die Kapazität 110 der Schaltung eingeht.

Im Unterschied zu der Ausführungsform gemäß Figur 2, 3 hat die Schicht 140 bei der hier betrachteten Ausführungsform eine doppelte Funktion, nämlich die Funktion des Substrats und die Funktion eines Dielektrikums. Hierdurch kann eine noch geringe Bauhöhe erzielt werden. Die vollständige Kapselung des LED-Moduls 102 in der Ausführungsform gemäß Figur 7 kann dadurch erreicht werden, dass eine Schicht 142 auch auf die Unterseite aufgebracht wird oder indem das LED-Modul 102 in einer Materialschicht 154 (vgl. Fig. 5) eingebettet wird.

Die Figuren 8 und 9 zeigen eine Ausführungsform des LED-Moduls 102, bei der je eine Antennenleiterbahn 120.1 auf der Oberseite der Schicht 140 und eine Antennenleiterbahn 120.2 auf der Rückseite der Schicht 140 verläuft, sodass die zwischen den Antennenleiterbahnen 120.1 und 120.2 liegende Schicht 140 als Dielektrikum hinsichtlich der parasitären Kapazität der sich gegenüberliegenden Antennenleiterbahnen wirkt. Bei dieser Ausführungsform sind die Anschlüsse, das heißt die Höcker 130 und 132 der LED 106, wiederum auf derselben Seite.

Der Höcker 130 ist mit der Antennenleiterbahn 120.1 verbunden, welche über ein Via 126 mit der Antennenleiterbahn 120.2 verbunden ist. Das Ende der Antennenleiterbahn 120.2 ist über ein weiteres Via 168 mit dem anderen Höcker 132 der LED 106 verbunden. Durch diese Anordnung der Antenne 118 wird eine relativ große parasitäre Kapazität erzeugt, sodass auf dem flächigen Bereich 136 bzw. eine flächige Ausbildung der Elektrode 124 bzw. des Elektrodenabschnitts 124.1 hier ganz oder teilweise verzichtet werden kann.

### Bezugszeichenliste

- 100: elektronisches System
- 102: LED-Modul
- 104: bewegliches Gut
- 106: LED
- 108: Induktivität
- 110: Kapazität
- 112: elektronisches Gerät
- 114: Primärschwingkreis
- 116: Substrat
- 118: Antenne
- 120: Antennenleiterbahn
- 122: Spulenöffnung
- 124: Elektrode
- 126: Via
- 128: Elektrode
- 130: Höcker
- 132: Höcker
- 134: Vorsprung
- 136: flächiger Bereich
- 138: Vorsprung
- 140: Schicht
- 142: Schicht
- 144: Licht
- 146: Material
- 148: Abstand
- 150: Fassung
- 152: Schmuckelement
- 154: Materialschicht
- 156: App
- 158: Kamera
- 160: Touchpanel
- 168: Via
- 170: Speicher
- 172: Prozessor
- 174: Kommunikationsschnittstelle

## Patentansprüche

1. LED-Modul (102) aufweisend einer Schaltung,
wobei die Schaltung eine Leuchtdiode, LED, (106) und einen Schwingkreis (108, 110) zur Einkopplung von Energie zum Betrieb der LED (106) aufweist,
wobei die Schaltung in dem LED-Modul (102) vollständig gekapselt und anschlusslos ist,
wobei die LED (106) erste und zweite Anschlüsse (130, 132) aufweist,
wobei die Schaltung erste und zweite Elektroden (124, 128) zur Kontaktierung der LED (106) aufweist,
wobei der Schwingkreis (108, 110) eine Leiterbahn (120) als Antenne (118) aufweist,
**dadurch gekennzeichnet, dass**
das LED-Modul (102) einen Schichtaufbau mit einem Dielektrikum (140) mit einer ersten Seite und einer zweiten, der ersten Seite gegenüberliegende Seite aufweist,
wobei ein Abschnitt (124.1) der ersten Elektrode (124) auf der ersten Seite des Dielektrikums (140) angeordnet ist und die zweite Elektrode (128) auf der zweiten Seite des Dielektrikums (140) angeordnet ist, sodass hierdurch eine Kapazität für den Schwingkreis (108, 110) gebildet wird,
wobei die ersten und zweiten Anschlüsse (130, 132) sich auf der zweiten Seite des Dielektrikums (140) befinden,
wobei der erste Anschluss (130) der LED (106) mit dem Abschnitt (124.1) der ersten Elektrode (124) über ein erstes Via (168), welches durch das Dielektrikum (140) hindurch verläuft, verbunden ist,
wobei die Leiterbahn (120) der Antenne (118) des Schwingkreises (108, 110) auf der ersten Seite des Dielektrikums (140) angeordnet ist und mit der zweiten Elektrode (128) durch ein zweites Via (126), welches durch das Dielektrikum (140) hindurch verläuft, verbunden ist, und
wobei die Leiterbahn (120) mehrere Antennenwindungen der Antenne (118) bildet, wobei die zweite Elektrode (128) mit dem zweiten Anschluss (132) der LED (106) verbunden ist.

2. LED-Modul (102) nach Anspruch 1, wobei die Resonanzfrequenz des Schwingkreises (108, 110) durch die Induktivität der Antenne (118) und eine Kapazität des Schwingkreises (108, 110) als eine Summe der Kapazität der LED (106), als einer ersten Kapazität, und der durch die ersten und zweiten Elektroden (124, 128) mit dem dazwischen befindlichen Dielektrikum gebildeten Kapazität, als einer zweiten Kapazität, gegeben ist und/oder wobei die Antennenwindungen eine Spulenöffnung (122) bilden, innerhalb derer sich auf der ersten Seite des Dielektrikums (140) die erste Elektrode (124; 124.1) befindet, wobei sich auf der zweiten Seite des Dielektrikums über die Spulenöffnung ein flächiger Bereich (136) der zweiten Elektrode erstreckt, wobei die zweite Elektrode (128) einen Vorsprung (138) aufweist, der den flächigen Bereich (136) und das zweite Via (126) miteinander verbindet, wobei sich der Vorsprung (138) über die Antennenwindungen (120) erstreckt.

3. LED-Modul (102) nach einem der vorhergehenden Ansprüche 1 bis 2, wobei die parasitäre Kapazität der Antennenwindungen eine dritte Kapazität für den Schwingkreis (108, 110) bildet.

4. LED-Modul (102) nach Anspruch 3, wobei die Antennenwindungen (120.1, 120.2) sowohl auf der ersten als auch auf der zweiten Seite des Dielektrikums (140) angeordnet sind, wobei die Antennenwindungen über Vias (126, 168), welche durch das Dielektrikum (140) hindurch verlaufen, miteinander verbunden sind.

5. LED-Modul (102) nach einem der vorhergehenden Ansprüche 1 bis 4, wobei die Breite der Leiterbahn der jeweiligen Antennenwindung zwischen 5 und 15 µm, vorzugsweise 10 µm, beträgt und wobei der Abstand zwischen zwei benachbarten Antennenwindungen zwischen 5 µm und 15 µm, vorzugsweise 10 µm besteht, und wobei die Anzahl der Windungen zwischen 20 und 60 Windungen, insbesondere 40 Windungen beträgt.

6. LED-Modul (102) nach einem der vorhergehenden Ansprüche, wobei in einem Lichtpfad des von der LED (106) abzustrahlenden Lichts ein optisch wirksames Material (146) angeordnet ist, insbesondere ein fluoreszierender oder phosphorizierender Stoff, ein Farbstoff zur Filterung des Lichts, ein Konversionsleuchtstoff, zum Beispiel für eine Up-Conversion oder Down-Conversion zur Verschiebung des Emissionsspektrums des Lichts, Effektpigmente, wie zum Beispiel Metalloxidpartikel und/oder retroreflektierende Partikel, und/oder
wobei die Resonanzfrequenz des Schwingkreises (108, 110) zwischen 10 MHz und 16 MHz, insbesondere 13,56 MHz beträgt, und/oder wobei die LED eine Dicke von weniger als 100 µm, insbesondere weniger als 60 µm, insbesondere 50 µm aufweist und das LED-Modul (102) eine Bauhöhe von weniger als 7000 µm, insbesondere weniger als 5000 µm, insbesondere weniger als 100 µm, insbesondere zwischen 30 µm und 100 µm aufweist, wobei eine laterale Abmessung des LED-Moduls (102) weniger als 5 mm, insbesondere weniger als 3 mm, insbesondere weniger als 1 mm, beispielsweise 500 µm, beträgt.

7. Papier mit einem oder mehreren in oder auf dem Papier angeordneten LED-Modulen (102) nach einem der vorhergehenden Ansprüche.

8. Kunststoff oder Textilie mit einem oder mehreren in oder auf dem Kunststoff oder der Textilie angeordneten LED-Modulen (102) nach einem der vorhergehenden Ansprüche 1 bis 6.

9. Wert- oder Sicherheitsdokument mit einem Dokumentenkörper in oder auf dem ein oder mehrere LED-Module (102) nach einem der vorhergehenden Ansprüche 1 bis 6 angeordnet sind.

10. Bewegliches Gut (104), umfassend eines von einem Schmuckstück, einem Kleidungsstück, einem Behälter, insbesondere Getränkebehälter, einem elektronischen Gerät, einem Maschinenteil, einem Ersatzteil, einem Medikament oder einer Verpackung, mit zumindest einem LED-Modul (102) nach einem Ansprüche 1 bis 6.

11. Elektronisches System (100) mit einem elektronischen Gerät (112), insbesondere einem Mobilfunkgerät oder einem Kassenterminal, und einem Papier nach Anspruch 7, Kunststoff oder einer Textilie nach Anspruch 8 oder einem Wert- oder Sicherheitsdokument nach Anspruch 9 oder einem beweglichen Gut (104) nach Anspruch 10, wobei das elektronische Gerät (112) einen Primärschwingkreis (114) zur Anregung des Schwingkreises (108, 110) des zumindest einen LED-Moduls (102) aufweist, wobei auf eine Anregung des Schwingkreises (108, 110) hin von dem LED-Moduls (102) Licht (144) abgestrahlt wird, welches die Echtheit des Papiers, Kunststoffs, der Textilie bzw. des Wert- oder Sicherheitsdokuments bzw. des beweglichen Guts (104) signalisiert.

12. Elektronisches System (100) nach Anspruch 11, wobei das elektronische Gerät (112)dazu konfiguriert ist, in Antwort auf einen von dem Primärschwingkreis (114) des elektronischen Geräts (112) gesendeten Impuls eine von der Antenne (118) des LED-Moduls (102) gesendete Impulsantwort des LED-Moduls (102) mithilfe des Primärschwingkreises (114) zu erfassen und auf hinreichende Übereinstimmung mit ersten hinterlegten Referenzdaten zu prüfen, und wenn eine hinreichende Übereinstimmung vorliegt, den Primärschwingkreis (114) zur Anregung des Schwingkreises (108, 110) zum Ansteuern des LED-Moduls (102) anzusteuern, so dass das LED-Modul (102) aufleuchtet, und/oder
wobei das elektronische Gerät (112) einen optischen Sensor, beispielsweise eine Kamera (158), aufweist, um das von dem LED-Modul (102) abgestrahlte Licht (144) zu erfassen und mit zweiten hinterlegten Referenzdaten zu vergleichen, wobei wenn eine hinreichende Übereinstimmung mit den zweiten Referenzdaten vorliegt, das elektronische Gerät (112) ein Signal erzeugt, welches die hinreichende Übereinstimmung mit den zweiten Referenzdaten anzeigt.

## Claims

1. An LED module (102), comprising a circuit,
the circuit comprising a light-emitting diode, LED, (106) and a resonant circuit (108, 110) for coupling in energy for operating the LED (106),
the circuit being fully encapsulated in the LED module (102) and formed without connections,
the LED (106) comprising first and second terminals (130, 132),
the circuit comprising first and second electrodes (124, 128) for contacting the LED (106),
the resonant circuit (108, 110) comprising a conductive track (120) serving as an antenna (118),
**characterized in that**
the LED module (102) has a layered design comprising a dielectric (140) having a first side and a second side located opposite the first side,
a portion (124.1) of the first electrode (124) being arranged on the first side of the dielectric (140), and the second electrode (128) being arranged on the second side of the dielectric (140), by which a capacitance for the resonant circuit (108, 110) is formed,
the first and second terminals (130, 132) being located on the second side of the dielectric (140),
the first terminal (130) of the LED (106) being connected to the portion (124.1) of the first electrode (124) by way of a first via (168) extending through the dielectric (140),
the conductive track (120) of the antenna (118) of the resonant circuit (108, 110) being arranged on the first side of the dielectric (140) and being connected to the second electrode (128) by way of a second via (126) extending through the dielectric (140),
the conductive track (120) forming a plurality of antenna windings of the antenna (118), and the second electrode (128) being connected to the second terminal (132) of the LED (106).

2. The LED module (102) according to claim 1, wherein the resonant frequency of the resonant circuit (108, 110) is given by the inductance of the antenna (118) and a capacitance of the resonant circuit (108, 110) as a sum of the capacitance of the LED (106), as a first capacitance, and the capacitance formed by the first and second electrodes (124, 128) with the dielectric arranged therebetween, as a second capacitance, and/or
wherein the antenna windings form a coil opening (122), within which the first electrode (124; 124.1) is arranged on the first side of the dielectric (140), a flat region (136) of the second electrode extending over the coil opening on the second side of the dielectric, the second electrode (128) including a protrusion (138) which connects the flat region (136) and the second via (126) to one another, and the protrusion (138) extending over the antenna windings (120).

3. An LED module (102) according to any one of the preceding claims 1 to 2, wherein the parasitic capacitance of the antenna windings forms a third capacitance for the resonant circuit (108, 110).

4. The LED module (102) according to claim 3, wherein the antenna windings (120.1, 120.2) are arranged both on the first side and on the second side of the dielectric (140), the antenna windings being connected to one another by way of vias (126, 168) extending through the dielectric (140).

5. An LED module (102) according to any one of the preceding claims 1 to 4, wherein the width of the conductive track of the respective antenna winding is between 5 and 15 µm, preferably 10 µm, and the distance between two adjoining antenna windings is between 5 µm and 15 µm, preferably 10 µm, and the number of windings is between 20 and 60 windings, in particular 40 windings.

6. An LED module (102) according to any one of the preceding claims, wherein an optically effective material (146) is arranged in a light path of the light to be emitted by the LED (106), in particular a fluorescent or phosphorescent substance, a dye for filtering the light, a conversion luminophore, for example for an up-conversion or a down-conversion for shifting the emission spectrum of the light, effect pigments, such as metal oxide particles, and/or retroreflective particles, and/or
wherein the resonance frequency of the resonant circuit (108, 110) is between 10 MHz and 16 MHz, in particular 13.56 MHz, and/or
wherein the LED has a thickness of less than 100 µm, in particular less than 60 µm, in particular 50 µm, and the LED module (102) has a height of less than 7000 µm, in particular less than 5000 µm, in particular less than 100 µm, in particular between 30 µm and 100 µm, a lateral dimension of the LED module (102) being less than 5 mm, in particular less than 3 mm, in particular less than 1 mm, for example 500 µm.

7. A paper, comprising one or more LED modules (102) according to any one of the preceding claims arranged in or on the paper.

8. A plastic or textile, comprising one or more LED modules (102) according to any one of the preceding claims 1 to 6 arranged in or on the plastic or the textile.

9. A value or security document, comprising a document body in or on which one or more LED modules (102) according to any one of the preceding claims 1 to 6 are arranged.

10. A movable article (104), comprising one of a piece of jewelry, an item of clothing, a container, in particular a beverage container, an electronic device, a machine part, a replacement part, a pharmaceutical drug, or a packaging, comprising at least one LED module (102) according to any one of claims 1 to 6.

11. An electronic system (100), comprising an electronic device (112), in particular a mobile communication unit or a point-of-sale terminal, and a paper according to claim 7, a plastic or a textile according to claim 8 or a value or security document according to claim 9, or a movable article (104) according to claim 10, wherein the electronic device (112) comprises a primary resonant circuit (114) for exciting the resonant circuit (108, 110) of the at least one LED module (102), in response to an excitation of the resonant circuit (108, 110) light (144) being emitted by the LED module (102) which signals the authenticity of the paper, of the plastic, of the textile or of the value or security document or of the movable article (104).

12. The electronic system (100) according to claim 11, wherein the electronic device (112) is configured to detect a pulse response of the LED module (102), which is transmitted by the antenna (118) of the LED module (102) in response to a pulse transmitted by the primary resonant circuit (114) of the electronic device (112), with the aid of the primary resonant circuit (114) and to check it for sufficient agreement with first stored reference data, and, when sufficient agreement is present, to activate the primary resonant circuit (114) for excitation of the resonant circuit (108, 110) for the activation of the LED module (102) so that the LED module (102) is illuminated, and/or
wherein the electronic device (112) comprises an optical sensor, for example a camera (158), so as to sense the light (144) emitted by the LED module (102) and to compare it to second stored reference data, the electronic device (112), when sufficient agreement with the second reference data exists, generating a signal which indicates the sufficient agreement with the second reference data.

## Revendications

1. Module de DEL (102) présentant un circuit,
dans lequel le circuit présente une diode électro luminescente, DEL, (106) et un circuit résonnant (108, 110) permettant un couplage d'énergie pour le fonctionnement de la DEL (106), dans lequel le circuit est totalement encapsulé dans le module de DEL (102) et est sans connexion,
dans lequel la DEL (106) présente des premiers et deuxièmes connecteurs (130, 132), dans lequel le circuit présente des première et deuxième électrodes (124, 128) pour la mise en contact avec la DEL (106),
dans lequel le circuit résonnant (108, 110) présente une piste conductrice (120) servant d'antenne (118),
**caractérisé en ce que**
le module de DEL (102) présente une structure en couches avec un diélectrique (140) muni d'une première face et d'une deuxième face, opposée à la première face,
dans lequel un segment (124.1) de la première électrode (124) est disposé sur la première face du diélectrique (140) et la deuxième électrode (128) est disposée sur la deuxième face du diélectrique (140), de sorte qu'ainsi on forme une capacité pour le circuit résonnant (108, 110),
dans lequel les premiers et les deuxièmes connecteurs (130, 132) se situent sur la deuxième face du diélectrique (140),
dans lequel le premier connecteur (130) de la DEL (106) est relié avec le segment (124.1) de la première électrode (124) par le biais d'un premier via (168), lequel traverse le diélectrique (140) de part en part,
dans lequel la piste conductrice (120) de l'antenne (118) du circuit résonnant (108, 110) est disposée sur la première face du diélectrique (140) et est reliée avec la deuxième électrode (128) par un deuxième via (126), lequel traverse le diélectrique (140) de part en part, et
dans lequel la piste conductrice (120) forme plusieurs enroulements d'antenne de l'antenne (118), dans lequel la deuxième électrode (128) est reliée avec le deuxième connecteur (132) de la DEL (106).

2. Module de DEL (102), selon la revendication 1, dans lequel la fréquence de résonance du circuit résonnant (108, 110) est donnée par l'inductivité de l'antenne (118) et une capacité du circuit résonnant (108, 110) sous la forme d'une somme de la capacité de la DEL (106), sous la forme d'une première capacité, et de la capacité formée par les première et deuxième électrodes (124, 128) avec le diélectrique se situant entre elles, sous la forme d'une deuxième capacité, et/ou
dans lequel les enroulements d'antenne forment un orifice de bobine (122) à l'intérieur duquel se trouve le première électrode (124 ; 124.1) sur la première face du diélectrique (140), dans lequel une région plane (136) de la deuxième électrode s'étend sur la deuxième face du diélectrique au-dessus l'orifice de bobine, dans lequel la deuxième électrode (128) présente une protubérance (138) qui relie la région plane (136) et le deuxième via (126) l'un à l'autre, dans lequel la protubérance (138) s'étend par-dessus les enroulements d'antenne (120).

3. Module de DEL (102) selon l'une des revendications précédentes 1 à 2, dans lequel la capacité parasitaire des enroulements d'antenne forme une troisième capacité pour le circuit résonnant (108, 110).

4. Module de DEL (102), selon la revendication 3, dans lequel les enroulements d'antenne (120.1, 120.2) sont disposés à la fois sur la première face et sur la deuxième face du diélectrique (140), dans lequel les enroulements d'antenne sont reliés entre eux par le biais de vias (126, 168), lesquels traversent le diélectrique (140) de part en part.

5. Module de DEL (102) selon l'une des revendications précédentes 1 à 4, dans lequel la largeur de la piste conductrice des enroulements d'antenne respectifs se situe entre 5 et 15 µm, de préférence à 10 µm, et dans lequel la distance entre deux enroulements d'antenne voisins est entre 5 µm et 15 µm, de préférence à 10 µm, et dans lequel le nombre d'enroulements se situe entre 20 et 60 enroulements, notamment à 40 enroulements.

6. Module de DEL (102) selon l'une des revendications précédentes, dans lequel un matériau actif de manière optique (146), notamment une substance fluorescente ou phosphorescente, un colorant pour la filtration de la lumière, une substance luminescente de conversion, par exemple, destinée à une conversion up ou une conversion down permettant le décalage du spectre d'émission de la lumière, des pigments à effets, comme, par exemple, des particules d'oxydes métalliques et/ou des particules rétro réfléchissantes, est disposé dans un trajet lumineux de la lumière émise par la DEL (106),
dans lequel la fréquence de résonance du circuit résonnant (108, 110) se situe entre 10 MHz et 16 MHz, notamment à 13,56 MHz, et/ou
dans lequel la DEL présente une épaisseur inférieure à 100 µm, notamment inférieure à 60 µm, notamment 50 µm, et le module de DEL (102) présente une hauteur de structure inférieure à 7000 µm, notamment inférieure à 5000 µm, notamment inférieure à 100 µm, en particulier, entre 30 µm et 100 µm, dans lequel la dimension latérale du module de DEL (102) se situe inférieure à 5 mm, notamment inférieure à 3 mm, en particulier inférieure à 1 mm, par exemple à 500 µm.

7. Papier avec un ou plusieurs modules de DEL (102) selon l'une des revendications précédentes disposés dans ou sur le papier.

8. Matière plastique ou textile avec un ou plusieurs modules de DEL (102) selon l'une des revendications précédentes 1 à 6 disposés dans ou sur la matière plastique ou le textile.

9. Document de valeur ou de sécurité avec un corps de document dans lequel ou sur lequel sont disposés un ou plusieurs modules de DEL (102) selon l'une des revendications précédentes 1 à 6.

10. Article mobile (104), comprenant un article parmi un bijou, un vêtement, un récipient, notamment un récipient pour des boissons, un appareil électronique, une pièce de machine, une pièce de rechange, un médicament ou un emballage, avec au moins un module de DEL (102) selon l'une des revendications 1 à 6.

11. Système électronique (100) doté d'un appareil électronique (112), notamment d'un appareil radio mobile ou d'un terminal de caisse, et d'un papier selon la revendication 7, de matière plastique ou d'un textile selon la revendication 8, ou d'un document de valeur ou de sécurité selon la revendication 9, ou d'un article mobile (104) selon la revendication 10, dans lequel l'appareil électronique (112) comprend un circuit résonnant primaire (114) pour l'excitation du circuit résonnant (108, 110) de l'au moins un module de DEL (102), dans lequel, suite à une excitation du circuit résonnant (108, 110) par le module de DEL (102), de la lumière (144) est émise, laquelle signale l'authenticité du papier, de la matière plastique, du textile, respectivement, du document de valeur ou de sécurité, respectivement de l'article mobile (104).

12. Système électronique (100) selon la revendication 11, dans lequel l'appareil électronique (112) est conçu pour, en réponse à une impulsion envoyée par le circuit résonnant primaire (114) de l'appareil électronique (112), détecter une réponse d'impulsion du module de DEL (102) envoyée par l'antenne (118) du module de DEL (102) à l'aide du circuit résonnant primaire (114) et pour vérifier la présence d'une concordance suffisante avec des premières données de référence enregistrées, et lorsqu'il y a une concordance suffisante, pour démarrer le circuit résonnant primaire (114) pour l'excitation du circuit résonnant (108, 110) afin de démarrer le module de DEL (102) de sorte que le module de DEL (102) s'éclaire, et/ou
dans lequel l'appareil électronique (112) présente un capteur optique, par exemple, une caméra (158), afin de détecter la lumière (144) émise par le module de DEL (102) et afin de comparer avec des deuxièmes données de référence enregistrées, dans lequel, s'il y a une concordance suffisante avec les deuxièmes données de référence, l'appareil électronique (112) génère un signal, lequel indique la concordance suffisante avec les deuxièmes données de référence.
